Europäisches Patentamt

European Patent Office

Office européen des brevets

(11) Publication number: **0 149 089**
**B1**

(12) **EUROPEAN PATENT SPECIFICATION**

(45) Date of publication of patent specification: **23.11.89**

(51) Int. Cl.⁴: **H 01 J 37/32**

(21) Application number: **84114632.7**

(22) Date of filing: **01.12.84**

(54) **Single electrode, multiple frequency plasma apparatus.**

(30) Priority: **06.01.84 US 568859**

(43) Date of publication of application:
**24.07.85 Bulletin 85/30**

(45) Publication of the grant of the patent:
**23.11.89 Bulletin 89/47**

(84) Designated Contracting States:
**DE GB**

(56) References cited:
**EP-A-0 019 370**
**EP-A-0 026 604**

**PATENTS ABSTRACTS OF JAPAN, vol. 8, no.
99 (E-243) 1536r, 10th May 1984; & JP - A - 59
17 237**

**PATENTS ABSTRACTS OF JAPAN, vol. 5, no.
86 (E-60) 758r, 5th June 1981; & JP - A - 56 33
839**

(73) Proprietor: **TEGAL CORPORATION**
**11 Digital Drive**
**Novato California 94947 (US)**

(72) Inventor: **Celestino, Salvatore A.**
**1000 Ignacio Boulevard**
**Novato, California 94947 (US)**
Inventor: **Gorin, Georges J.**
**1847 Hoke Court**
**Pinole, California 94564 (US)**
Inventor: **Hilliker, Stephen E.**
**2000 Clelia Lane**
**Petaluma, California 94952 (US)**
Inventor: **Powell, Gary B.**
**20 West Street**
**Petaluma, California 94952 (US)**

(74) Representative: **Ibbotson, Harold et al
Motorola Ltd Patent and Licensing Operations -
Europe Jays Close Viables Industrial Estate
Basingstoke Hampshire RG22 4PD (GB)**

Courier Press, Leamington Spa, England.

## Description

Field of the Invention

The present invention relates, in general, to plasma reactors and their use. More particularly, the invention relates to apparatus for the plasma treatment of workpieces wherein more than one frequency is coupled to a single electrode within the apparatus.

Background of the Invention

Various equipment for treating workpieces with a plasma is increasing in importance, particularly in the area of manufacturing semiconductor devices. Thus, the investigation of the effects of different equipment configurations has been pursued. Of particular interest are the various etching processes used in semiconductor device manufacturing. It is increasingly necessary to produce very fine lines with such processes, which requires a high degree of process uniformity, flexibility and control. A need exists for apparatus which enables these processes to be accomplished in a production environment.

It has been discovered that a plasma reactor which is capable of applying power of more than one frequency to energize the plasma offers significant advantages in terms of process flexibility, control, and uniformity. However, the advantages of such a dual frequency process have only been achievable in triode reactors. Such reactors are structurally more complex and therefore may be commercially disadvantageous in some circumstances.

Apparatus for the plasma treatment of a workpiece in accordance with the prior art portion of claim 1 is known from EP-A-0026604. The disclosed prior art apparatus has the disadvantage of possible impedance mismatches which may result in inadequate suppression of harmonics of the two frequencies and possibly even damage to the signal sources.

Summary of the Invention

Accordingly, it is an object of the present invention to provide an improved plasma reactor apparatus in which plural frequencies are applied to a single electrode.

The above object is met by the apparatus of the invention in which there is provided a combining means for coupling both of said frequencies to but one of said electrodes while isolating the lower frequency power supply from the higher frequency power supply and suppressing heterodyne signals despite said glow discharge being a non-linear load. The combing means may comprise a multi-stage, passive filter network having at least one stage connected between said two power supplies for attenuating the higher frequency and at least one stage for attentuating undesired mixing products.

The multi-stage filter typically comprises a plurality of stages series connected between the lower frequency power supply means and said one electrode and wherein the power supply means for the higher frequency is connected between two of said stages.

An exemplary embodiment will be described with reference to detailed description below taken together with the drawings.

Brief Description of the Drawings

FIG. 1 is a schematic cross-sectional view of an apparatus according to a particular embodiment of the present invention; and

FIG. 2 is a schematic diagram of a combining means according to a particular embodiment of the present invention.

Detailed Description of the Invention

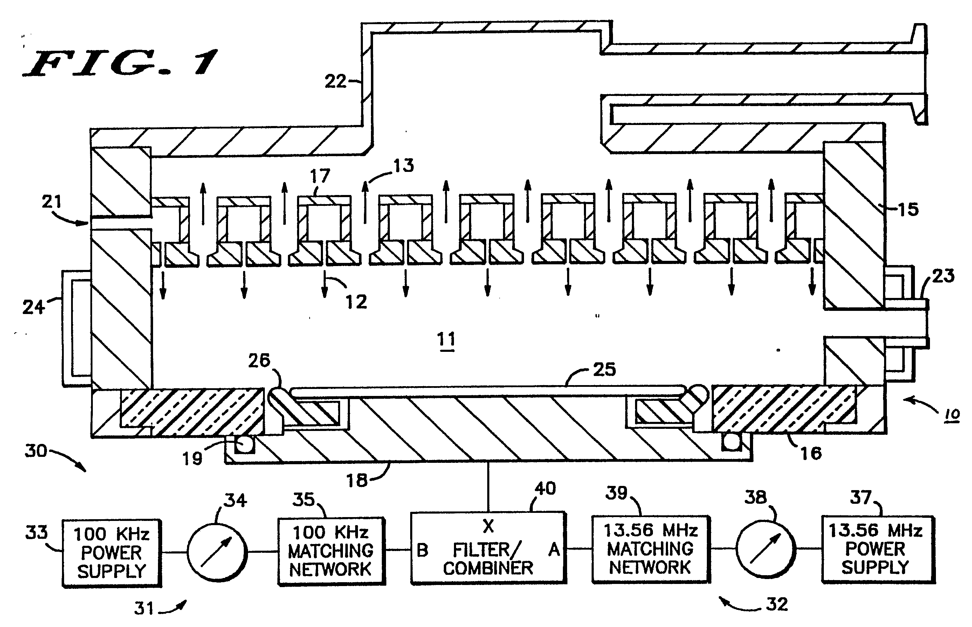

Referring to FIG. 1, a plasma reactor apparatus according to the principles of the present invention is illustrated in cross-section. Plasma reactor 10 is designed, in broad terms, to enclose a reaction volume 11, supply a reactive gas mixture 12 thereto, exhaust reaction products 13 therefrom, and impose an RF electric field therein. An enclosure 15 which includes a ceramic insulator lower portion 16, a manifold 17 and an electrode 18 serve to define reaction volume 11. Enclosure 15 is conductive and electrically grounded. Electrode 18 is adapted to sealably engage ceramic insulator 16 and is supplied with an O-ring seal 19 to accomplish an adequate seal therebetween. Manifold 17 is coupled to a supply means 21 and is adapted to supply reactive gas 12 to reaction volume 11. In addition, manifold 17 directs reaction products 13 comprising used and unused reactive gas and chemical products of the reaction to a vent 22 so that they may be exhausted by a vacuum pump which is not shown. Manifold 17 may be of the type disclosed in U.S. Patent 4,209,357 issued June 24, 1980 and assigned to the assignee of the present invention.

Plasma reactor apparatus 10 also includes an optical window 23 in enclosure 15 whereby the optical properties of the plasma in reaction volume 11 may be monitored. In addition, a temperature control device such as water jacket 24 is provided. As is well-known in the art, it is also common to provide temperature control devices such as water jackets and/or heating devices in electrode 18.

Electrode 18 serves the dual purpose of energizing reactive gas 12 and providing the means by which workpieces are loaded and unloaded from reaction volume 11. During the loading process electrode 18 is lowered away from ceramic insulator 16, whereby access to reaction volume 11 is provided. In addition, electrode 18 is adapted to serve as a workpiece holder. A semiconductor wafer 25, which is surrounded and carried by a wafer ring 26, is supported by electrode 18. This single electrode arrangement is particularly advantageous in that it readily interfaces with an automated wafer transport system.

A power supply apparatus 30 is coupled to electrode 18 for providing RF power thereto. According to the present invention, power supply apparatus 30 comprises a low frequency portion 31 and a high frequency portion 32. In the nomenclature associated with plasma reactors and plasma 15 processes it is common to describe as "high frequency" any frequency greater than about 10 MHz. Similarly, "low frequency" is used to describe any frequency less than approximately 1 MHz. The use of combined high and low frequencies has been described in apparatus for the plasma treatment of workpieces. It has not been known heretofore that more than one frequency could be coupled successfully to a single electrode in such apparatus.

In the particular case of this embodiment of the present invention, low frequency portion 31 of power supply 25 comprises a 100 KHz power supply 33, a power meter 34 and a 100 KHz matching network 35. Power meter 34 serves to monitor the power level of the 100 KHz power being supplied to reaction volume 11. Matching network 35 serves to optimize the transmission of 100 KHz power to electrode 18 by means of impedance matching. Matching network 35 can comprise, for instance, an impedance transformer. Similarly, high frequency portion 32 of power supply 30 comprises a 13.56 MHz power supply 37, a power meter 38 and a 13.56 MHz matching network 39. Matching network 39 can 35 comprise, for instance, an automated slug-tuned apparatus.

A combining means 40 is coupled between low frequency power supply 31, high frequency power supply 32 and electrode 18. Ports A and B of combining means 40 are coupled to high frequency power supply 32 and low frequency power supply 31, respectively. Port X of combining means 40 is coupled to electrode 18. Combining means 40 must serve three purposes which are unique to a plasma reactor having plural frequencies on a single electrode. First, the high frequency power must be largely prevented from reaching 10 the low frequency power supply to prevent damage. The converse of this isolation problem is provided by 13.56 MHz matching network 39. Second, the heterodyne products caused by the coupling of two different frequencies to a non-linear load (the plasma reactor) must be attenuated in order to 15 comply with government regulations. Third, the radiation emitted by the reactor and the various interconnections must be minimized.

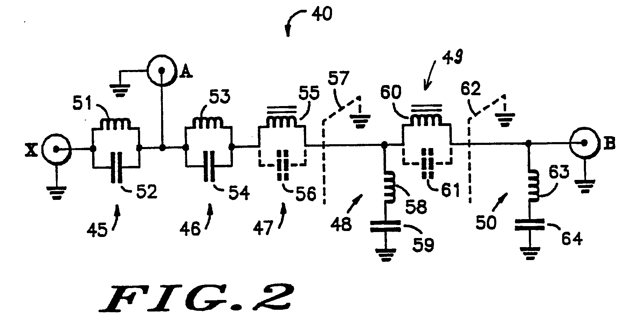

Referring now to FIG. 2, combining means 40 is shown schematically. Ports A, B and X are shown schematically as coaxial connectors, since the interconnection of the various elements is generally accomplished with coaxial cable. Each of the indicated ground connections in combining mean 40 is coupled to the same ground as is enclosure 15 (FIG. 1). This minimizes ground currents. In broad terms, combining means 40 comprises first through sixth stages 45, 46, 47, 48, 49 and 50, respectively, coupled between port X and port B. Port A is coupled out between first stage 45 and second stage 46.

First stage 45 is combining means 40 is a parallel tank circuit made up of inductor 51 and capacitor 52. In a particular embodiment, first stage 45 is intended to attenuate the 40.68 MHz heterodyne product. Inductor 51 has a value of 0.153 µh and capacitor 52 has a value of 100 pf.

Second stage 46 is also a tank circuit which comprises an inductor 53 and a capacitor 54. In the particular embodiment, second stage 46 is intended to attenuate the 13.56 MHz signal between ports A and B. This provides the required isolation and prevents stages three through six from altering the 13.56 MHz matching. Inductor 53 has a value of 1.38 µh and capacitor 54 has a value of 100 pf.

Third stage 47, which is connected in series with first stage 45 and second stage 46, comprises a cored inductor 55 and its parallel parasitic capacitance 56. In the particular embodiment, third stage 47 serves to attenuate the 27.12 MHz heterodyne product between ports X and B. Inductor 55 has a value of 10 µh and parasitic capacitance 56 has a value of 3.4 pf.

Fourth stage 48 is coupled between the line between ports X and B and ground. In addition, electro-magnetic coupling between third stage 47 and fourth stage 48 is prevented by grounded shield 57. Fourth stage 48 combines with first stage 45 and fifth stage 49 to attenuate the 40.68 MHz heterodyne product between ports X and B. Fourth stage 48 comprises an inductor 58 and a series-connected capacitor 59. Inductor 58 has a value of 0.2 µh and capacitor 59 has a value of 75 pf.

Fifth stage 49, another parallel tank circuit series-connected between ports X and B, comprises a cored inductor 60 and its parallel parasitic capacitance 61. Like fourth stage 48, it is resonant at 40.68 MHz in the particular embodiment. Inductor 60 has a value of 5 µh and parasitic capacitance 61 has a value of 3 pf.

A second grounded shield 62 separates fifth stage 49 from sixth stage 50. Sixth stage 50, which serves to attenuate the 67.8 MHz heterodyne product between ports X and B, comprises an inductor 63 and a series-connected, grounded capacitor 64. Inductor 63 has a value of 0.07 µh and capacitor 64 has a value of 75 pf.

Combining means 40 is typically augmented by ensuring good RF contact between the various panels which make up the cabinet of the plasma reactor apparatus to contain any radiation which might exist. Combining means 40 represents a delicate compromise between being able to provide good impedance matching and providing the necessary attenuation of harmonics.

The combination of high and low frequencies in plasma processes has been found to offer increased flexibility and control. Generally, this is due to the fact that the degree of dissociation and the ion energy cross-section in the plasma are strong functions of frequency, as is the ion 10 energy. In other words, different percent dissociations and ion energy cross-sections are produced at the high and low frequencies with higher ion energies being present in the low frequency discharge. Therefore, by controlling the relative power levels of the two power supplies in the disclose apparatus a process which combines a high etch rate with excellent residue removal is achievable.

In particular, a plasma reactor having two frequencies coupled to a single electrode is well-suited to metal etching processes. By way of example, a process for etching aluminum/silicon with an admixture of 1% copper is described. In this process, the 13.56 MHz power supply is operated at 250 watts and the 100 KHz power supply is operated at 20 watts. The reactive gas comprises 50 standard cubic centimeters per minute (SCCM) of carbon tetrachloride, 15 SCCM of chlorine and 40 SCCM of argon. The system operating pressure is maintained at 36 Pa (270 mtorr). The etch rate of this process is roughly 700 to 800 nm/min (7000 to 8000 A/min). It has been found that the described process provides excellent etching characteristics and further provides a surface which is substantially clear of organic and inorganic contaminants. Prior art metal etching processes generally leave substantial residues which may affect subsequent processing steps and the long term reliability of the finished device.

The plasma reactor apparatus described above provide an improvement in plasma processes. The present invention combines the advantages of a dual frequency plasma process with the simplicity and commercial advantage of a diode reactor. As described, the apparatus enables one to etch metals and obtain a substantially cleaner surface than the prior art.

While the present invention has been disclosed with reference to a particular embodiment thereof, various modifications and changes will be apparent to those skilled in the art and may be made without departing from the scope of the invention as defined by the claims.

## Claims

1. Apparatus for the plasma treatment of workpieces, comprising a pair of electrodes (17, 18) for defining a reaction volume (11) in which a workpiece is located; means (21) for supplying reactive gas to said reaction volume; means (22) for exhausting reaction products from said reaction volume; and at least two power supply means (33, 37) producing two different frequencies for inducing a glow discharge in said volume, characterised by:
a combining means (40) for coupling both of said frequencies to but one (18) of said electrodes while isolating the lower frequency power supply (33) from the higher frequency power supply (37) and suppressing heterodyne signals despite said glow discharge being a non-linear load.

2. The apparatus as set forth in claim 1 wherein said combining means comprises a multi-stage, passive filter network having at least one stage (46), connected between said two power supplies (33, 37), for attenuating the higher frequency and at least one stage (45) for attenuating undesired heterodyne mixing products.

3. The apparatus as set forth in claim 2 wherein said multi-stage filter comprises a plurality of stages (45, 50) series connected between the lower frequency power supply means (33) and said one electrode (18) and wherein the power supply means for the higher frequency is connected between two (45, 46) of said stages.

## Patentansprüche

1. Vorrichtung für die Plasmabehandlung von Werkstücken mit einem Paar von Elektroden (17, 18) zur Bildung eines Reaktionsvolumens (11), in das das Werkstück gesetzt ist; einer Einrichtung (21) zum Zuführen von reaktivem Gas zu dem Reaktionsvolumen; einer Einrichtung (22) zum Ausbringen der Reaktionsprodukte aus dem Reaktionsvolumen; und wenigstens zwei Energiezuführeinrichtungen (33, 37), die zwei unterschiedliche Frequenzen erzeugen, zur Induktion einer Glühentladung in das Volumen, gekennzeichnet durch:
eine Verbindungseinrichtung (40) zum Koppeln der beiden Frequenzen zu nur einer (18) der Elektroden, während die niedrigere Frequenzenergiezuführung (33) von der höherfrequenten Energiezuführung (37) isoliert wird und Überlagerungssignale unterdrückt werden, obwohl die Glühentladung eine nicht-lineare Last ist.

2. Vorrichtung nach Anspruch 1, wobei die Verbindungseinrichtung ein mehrstufiges Passiv-Filternetzwerk aufweist, das wenigstens eine Stufe (46) aufweist, die zwischen den beiden Energiezuführungen (33, 37) verbunden ist, zum Unterdrücken der höheren Frequenz, und wenigstens eine Stufe (45) aufweist, zum Unterdrücken ungewünschter, überlagerter, gemischter Produkte.

3. Vorrichtung nach Anspruch 2, wobei der mehrstufige Filter eine Mehrzahl von Stufen (45, 50)-Reihen aufweist, die zwischen der niedrigeren Frequenzenergiezuführeinrichtung (33) und dieser einen Elektrode (18) verbunden ist, und wobei die Energiezuführeinrichtung für die höhere Frequenz zwischen zwei (45, 46) der Stufen mit diesen verbunden ist.

## Revendications

1. Appareil de traitement de pièces par un plasma, comprenant une paire d'électrodes (17, 18) pour définir un volume de réaction (11) dans lequel est située une pièce; un moyen (21) pour fournir un gaz réactif audit volume de réaction; un moyen (22) pour évacuer les produits de réaction dudit volume de réaction; et au moins deux moyens d'alimentation en énergie (33, 37) produisant deux fréquences différentes pour induire une décharge luminescente dans ledit volume, caractérisé par:
un moyen mélangeur (40) pour coupler les deux fréquences à l'une (18) desdites électrodes tout en isolant l'alimentation en énergie de fréquence inférieure (33) de l'alimentation en énergie de fréquence supérieure (37) et en supprimant les signaux hétérodynes bien que ladite décharge luminescente soit une charge non linéaire.

2. Appareil selon la revendication 1, dans lequel ledit moyen mélangeur comprend un réseau multi-étage de filtres passifs ayant au moins un étage (46) branché entre lesdites deux alimentations en énergie (33, 37) pour atténuer la fréquence supérieure et au moins un étage (45) pour atténuer les produits de mélange hétérodyne non souhaités.

3. Appareil selon la revendication 2, dans lequel ledit filtre multi-étage comprend une pluralité d'étages (45, 50) en série branchés entre le moyen d'alimentation en énergie de fréquence inférieure (33) et ladite électrode (18) et dans lequel le moyen d'alimentation en énergie pour la fréquence supérieure est branché entre deux (45, 46) desdits étages.

**FIG. 1**

*FIG.2*